# DEMANDE DE BREVET EUROPEEN

(11) **EP 3 657 678 A1**
(43) Date de publication de la demande: **27.05.2020**
(21) Numéro de dépôt: 19210781.1
(22) Date de dépôt: 21.11.2019
(51) Int. Cl.: H03K 17/16

(54) **CIRCUIT DE COMMANDE DE TRANSISTORS DE PUISSANCE**

(30) Priorité: 23.11.2018 FR 1871796
(71) Demandeur: Commissariat à l'Energie Atomique et aux Energies Alternatives, 75015 Paris (FR)
(72) Inventeur: BERGOGNE, Dominique, 38054 GRENOBLE CEDEX 09 (FR)
(74) Mandataire: Cabinet Beaumont

(57) **Abrégé**

La présente description concerne un circuit de conversion d'un premier signal de commande (CTH), référencé à un premier potentiel (GND), en un deuxième signal (HCT) référencé à un deuxième potentiel variable (COM), comportant : un premier transistor (M6) entre une première borne (31) de fourniture dudit deuxième signal (HCT) et une deuxième borne (39) audit deuxième potentiel variable ; et au moins une première branche (7) comportant, en série entre une grille (G6) du premier transistor (M6) et une troisième borne (13) audit premier potentiel (GND), un deuxième transistor (M3), un premier élément résistif (R4) et un troisième transistor (M1), une grille du troisième transistor (M1) étant destinée à recevoir le premier signal (CTH) et une grille du deuxième transistor (M3) étant reliée à la deuxième borne (39), la grille du deuxième transistor étant en outre reliée, par un premier élément écrêteur (D1), à sa source.

## Description

### Domaine technique

La présente description concerne de façon générale les circuits électroniques et, plus particulièrement, les techniques d'amorçage d'interrupteurs réalisés en technologie haute tension. La présente description concerne plus particulièrement la commande des interrupteurs d'un bras d'onduleur.

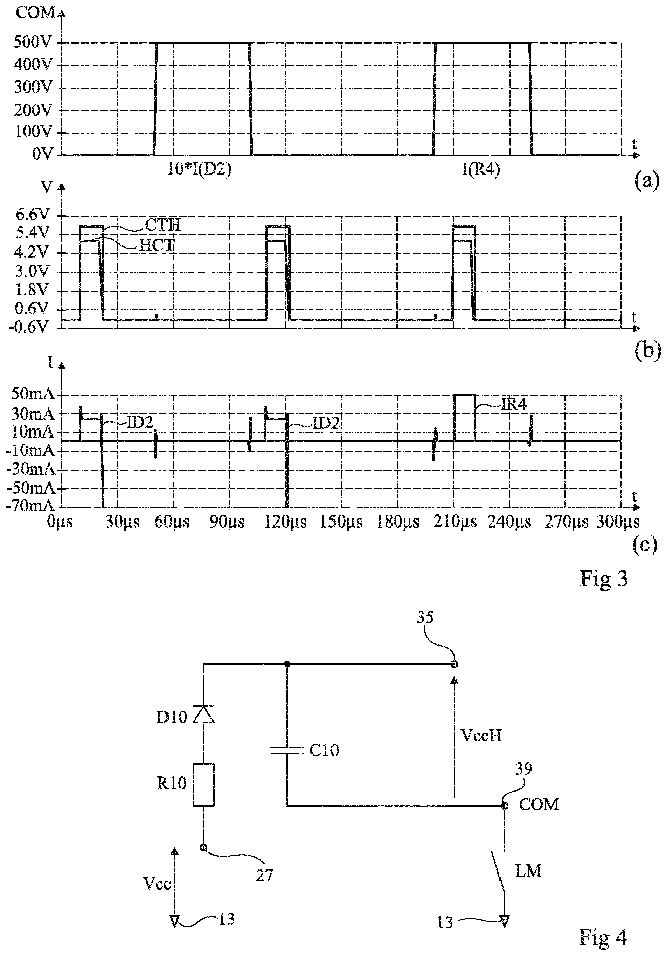

Le document "A 50V High-Speed Level Shifter with High dv/dt Immunity for Multi-MHz DCDC Converters" de J. Wittmann et al. (IEEE, 22 septembre 2014, pages 151-154, XP032672078) décrit, en relation avec ses figures 3(a) et 3(b), deux versions différentes de circuits décaleurs de niveau, respectivement avec diode et avec transistor PMOS monté en cascode.

Le document "Power Integrated Circuit Drives Based on HV NMOS" de S. Finco et al. (Annual Power Electronics Specialists Conference, 23 juin 2002, pages 1737-1740, XP010596000) décrit des circuits décaleurs de niveau basés sur des transistors NMOS.

### Technique antérieure

Les onduleurs de courant ou de tension sont particulièrement basés, dans les technologies récentes, sur l'emploi de transistors de puissance placés en série entre des bornes d'application d'une source de tension ou de courant et sont commandés de manière indépendante. Cette commande requiert classiquement l'emploi de circuits de commande (drivers) de ces transistors à partir de potentiels variables ou flottants. Cela conduit généralement à prévoir des éléments d'isolation galvanique, ce qui accroît le coût de la solution.

### Résumé de l'invention

Il existe un besoin d'amélioration des circuits de commande d'interrupteurs de puissance, en particulier dans des applications aux onduleurs.

Un mode de réalisation pallie tout ou partie des inconvénients des circuits de commande d'interrupteurs de puissance en série.

Un mode de réalisation prévoit une solution particulièrement simple.

Un mode de réalisation prévoit une solution particulièrement adaptée à des transistors à canal N dans des applications où la tension appliquée sur le drain des transistors est fortement supérieure à leur tension de grille.

Un mode de réalisation prévoit un circuit de conversion d'un premier signal de commande, référencé à un premier potentiel, en un deuxième signal référencé à un deuxième potentiel variable, comportant :
un premier transistor entre une première borne de fourniture dudit deuxième signal et une deuxième borne audit deuxième potentiel variable ; et
au moins une première branche comportant, en série entre une grille du premier transistor et une troisième borne audit premier potentiel, un deuxième transistor, un premier élément résistif et un troisième transistor, une grille du troisième transistor étant destinée à recevoir le premier signal et une grille du deuxième transistor étant reliée à la deuxième borne, la grille du deuxième transistor étant en outre reliée, par un premier élément écrêteur, à sa source
la grille du premier transistor étant reliée, par un deuxième élément résistif, à une troisième borne à un troisième potentiel, supérieur au deuxième potentiel.

Selon un mode de réalisation, ledit élément écrêteur force une mise en conduction du deuxième transistor lorsque le troisième transistor est rendu passant.

Selon un mode de réalisation, la première branche est active lorsque le deuxième potentiel variable est supérieur au premier potentiel.

Selon un mode de réalisation, le premier transistor est rendu passant quand le premier signal est dans un état rendant non conducteur le troisième transistor.

Selon un mode de réalisation, le circuit comporte en outre une deuxième branche en parallèle avec la première branche, entre la grille du premier transistor et la troisième borne.

Selon un mode de réalisation, la deuxième branche est destinée à être active lorsque le deuxième potentiel variable est sensiblement égal au premier potentiel.

Selon un mode de réalisation, la deuxième branche comporte, en série entre la grille du premier transistor et la troisième borne, un quatrième transistor, un deuxième élément écrêteur, une diode et un cinquième transistor, une grille du cinquième transistor étant destinée à recevoir l'inverse du premier signal et une source du quatrième transistor étant reliée à la deuxième borne, la grille du quatrième transistor étant en outre reliée au point milieu entre le deuxième élément écrêteur et la diode.

Selon un mode de réalisation, la deuxième branche est de structure similaire à la première branche, en étant commandée par l'inverse du premier signal.

Selon un mode de réalisation, les transistors sont des transistors MOS à canal N.

Un mode de réalisation prévoit un bras d'onduleur comportant :
un premier interrupteur et un deuxième interrupteur en série entre une première borne et une deuxième borne d'application d'une première tension ;
un circuit de conversion, la deuxième borne au potentiel variable représentant le point milieu de l'association en série des deux interrupteurs.

Selon un mode de réalisation, le deuxième signal est destiné à commander le premier interrupteur.

Selon un mode de réalisation, l'amplitude de la première tension est supérieure, dans un rapport d'au moins dix, à l'amplitude du premier signal de commande.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un exemple de bras d'onduleur du type auquel s'appliquent les modes de réalisation qui vont être décrits ;
la figure 2 représente le schéma électrique d'un mode de réalisation d'un circuit de transformation de signaux de commande et d'alimentation d'étages de commande (drivers) d'un bras d'onduleur ;
la figure 3 illustre, par des chronogrammes, le fonctionnement du circuit de la figure 2 ; et
la figure 4 représente, de façon simplifiée, un exemple de réalisation d'un montage Bootstrap.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la génération des signaux de commande en modulation de largeur ou de fréquence d'impulsions pour commander les interrupteurs de puissance n'a pas été détaillée, les modes de réalisation décrits étant compatibles avec les techniques actuelles de génération de tels signaux. De même, l'exploitation de l'énergie transférée par les interrupteurs de puissance, dont la commande est assurée par les circuits décrits, n'a pas été détaillée, les modes de réalisation décrits étant, là encore, compatibles avec les exploitations usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

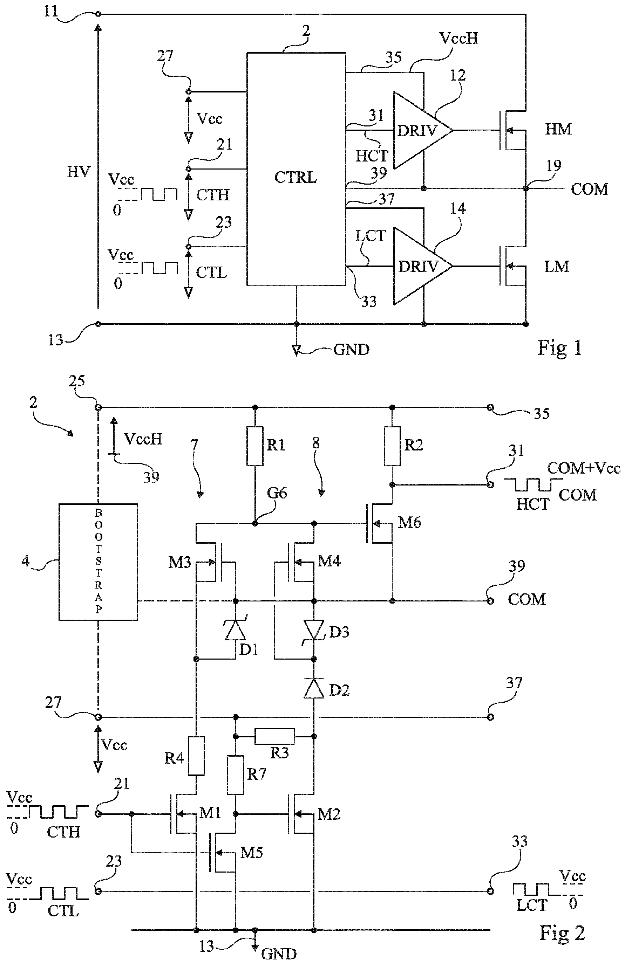

La figure 1 représente, de façon très schématique et sous forme de blocs, un exemple de bras d'onduleur du type auquel s'appliquent les modes de réalisation qui vont être décrits.

Un bras d'onduleur est basé sur deux interrupteurs de puissance HM et LM, typiquement des transistors à commande en tension (transistors MOS, transistors IGBT, transistor SiC, transistor HEMT en GaN, etc.), en série entre deux bornes 11 et 13 d'application d'une tension HV, typiquement une tension continue, référencée à une masse GND. Le potentiel de la borne 11 est donc un potentiel HV tandis que le potentiel de la borne 13 est de 0 volt. Le point milieu (borne 19) de l'association en série des deux interrupteurs HM et LM constitue la sortie du bras qui se trouve à un potentiel variant entre les potentiels des bornes 11 et 13. Par transistor de puissance, on entend des transistors dont la tension de grille est nettement inférieure (dans un rapport d'au moins 10 et le plus souvent d'au moins 100) à la tension présente sur le drain du transistor.

De façon habituelle, on utilise le mot tension pour définir une différence de potentiels entre deux bornes et le mot potentiel pour définir un niveau absolu, c'est-à-dire par rapport à la masse ou 0 volt.

Les transistors HM et LM sont, dans l'exemple représenté, des transistors de puissance dont les sources respectives sont reliées aux bornes 19 et 13. Les grilles respectives des transistors HM et LM reçoivent des signaux de commande (en tout ou rien) de circuits ou amplificateurs (drivers) 12 et 14 (DRIV). Les signaux de commande de grille des transistors HM et LM sont générés de sorte à éviter une conduction simultanée de ces deux transistors qui mettrait en court-circuit les bornes 11 et 13 d'entrée. Les circuits 12 et 14 reçoivent chacun un signal de commande HCT, respectivement LCT, d'un circuit de commande 2 (CTRL). Typiquement, chaque circuit 12, 14 comporte une structure de deux interrupteurs en série dont le point milieu fournit le signal de commande de grille du transistor HM, LM correspondant et dont les grilles reçoivent une information représentative du signal HCT, respectivement LCT. Il ne s'agit là que d'un exemple et les modes de réalisation décrits s'appliquent plus généralement à toute structure de circuit driver usuel.

En prenant l'exemple de la figure 1, où les transistors HM et LM sont des transistors à canal N, les signaux de sortie des circuits 12 et 14 doivent être respectivement référencés au potentiel COM de la borne 19 (pour le circuit 12) et au potentiel GND de la borne 13 (pour le circuit 14).

Pour cela, on prévoit le circuit de commande 2 (CTRL) dont le rôle est de fournir, aux circuits 12 et 14, non seulement des signaux de commande HCT et LCT correctement référencés, mais également des tensions d'alimentation également correctement référencées et compatibles avec la (basse) tension que ces circuits peuvent supporter.

Le circuit 2 est alimenté par une basse tension continue Vcc appliquée entre une borne 27 et la borne 13, soit référencée à la masse GND (le potentiel de la borne 27 vaut Vcc) et reçoit, sur des bornes 21 et 23, des signaux CTH et CTL numériques de consigne pour les commandes respectives des transistors HM et LM. Les signaux CTH et CTL sont des signaux numériques modulés en largeur d'impulsions et/ou en fréquence entre des potentiels respectivement sensiblement égaux à Vcc et à 0.

Pour simplifier, on néglige dans la présente description les chutes de tension dans des composants de type interrupteur à l'état passant. Par exemple, on fait référence à des signaux CTH et CTL commutant entre 0 et Vcc alors qu'en réalité ces niveaux sont décalés de quelques centaines de millivolts par les résistances à l'état passant des circuits qui les génèrent. Les signaux CTH et CTL sont fournis par des circuits numériques en amont qui modulent la largeur des impulsions et/ou la fréquence des trains d'impulsions des signaux CTH et CTL en fonction de l'application.

Dans le mode de réalisation illustré par la figure 1, le circuit 2 fournit sur des bornes 31 et 33 les signaux HCT et LCT qui sont d'amplitude proche de Vcc mais sont référencés respectivement aux potentiels COM et GND. Le circuit 2 fournit également, entre une borne 35 et une borne 39 reliée, de préférence connectée, à la borne 19, une basse tension continue VccH d'alimentation du circuit 12 (typiquement d'amplitude approximativement égale à la tension Vcc). Le circuit 2 fournit en outre, entre une borne 37 et la borne 13, une basse tension d'alimentation du circuit 14 (typiquement de valeur approximativement égale à Vcc) référencée à la masse GND.

Le circuit 14, associé au transistor LM, peut être commandé directement par le signal CTL (LCT = CTL) dans la mesure où il possède un potentiel de référence commun (la masse GND) avec ce signal. Ainsi, le circuit 14 peut être directement alimenté par la tension Vcc référencée à la masse GND (borne 13). La borne 23 est alors reliée, de préférence connectée, à la borne 37. Toutefois, côté circuit 12, le potentiel COM de la borne 39 varie, en négligeant les chutes de tension dans les transistors HM et LM à l'état passant, entre la masse 13 (transistor LM passant) et le potentiel de la borne 11, soit le potentiel haut de la tension HV (transistor HM passant). Le circuit 2 doit donc transposer le signal CTH, commutant entre les potentiels 0 et Vcc, en un signal HCT commutant entre les potentiels COM et COM + Vcc. De plus, le potentiel COM varie entre 0 (transistor LM passant) et HV (transistor HM passant).

La tension HV est par ailleurs généralement supérieure à la tension que peuvent supporter les circuits logiques et les amplificateurs 12 et 14. Typiquement, dans des applications, dites de puissance, la tension HV est au moins 10 fois supérieure (généralement de l'ordre de 100 fois supérieure) à la tension Vcc qui correspond à la tension des circuits logiques. Pour prendre un exemple particulier et choisi arbitrairement, on peut considérer le cas d'une tension HV de l'ordre de 400-500 volts et une tension Vcc de l'ordre de 4-6 volts.

Classiquement, pour résoudre le problème de référence de tension de l'étage haut (circuit 12), on utilise un élément d'isolation galvanique de type transformateur ou optocoupleur dont le rôle est de fonctionner en décaleur de niveau (Level Shifter) pour décaler le niveau du signal CTH. De tels éléments d'isolation galvanique ne sont toutefois pas intégrables, y compris dans des technologies désormais disponibles, où des composants basse tension et des composants haute tension peuvent être intégrés sur une même puce.

L'obtention de la (basse) tension d'alimentation du circuit 12 (entre les bornes 35 et 39) à partir de la tension Vcc référencée à la masse est moins problématique car elle peut être obtenue à l'aide d'un montage généralement appelé Bootstrap. Un tel montage, basé sur une diode haute tension entre les bornes 27 et 35 et un condensateur entre les bornes 35 et 39, est intégrable dans une technologie haute tension.

La figure 2 représente le schéma électrique d'un mode de réalisation d'un circuit de transformation de signaux de commande et d'alimentation d'étages de commande (drivers) d'un bras d'onduleur.

Le circuit 2 de la figure 2 comporte trois bornes d'entrée 27, 21 et 23, respectivement d'application d'une tension continue d'alimentation Vcc référencée à la masse et de signaux de commande CTH et CTL, également référencés à la masse GND. Tous ces signaux sont basse-tension (typiquement inférieurs à environ 10 volts, de préférence de l'ordre de 4 à 6 volts).

Le circuit 2 comporte par ailleurs une borne 39 destinée à être reliée, de préférence connectée, à la borne 19 (point milieu entre les transistors HM et LM) et deux bornes 35 et 37 de fourniture de potentiels hauts de tensions d'alimentation des circuits 12 et 14, les potentiels bas respectifs correspondant aux potentiels des bornes 39 et 13. De préférence, la tension VccH fournie entre les bornes 35 et 39 et la tension Vcc fournie entre les bornes 37 et 13 sont de même amplitude mais sont respectivement référencées aux potentiels COM et GND des bornes 39 et 13. Deux bornes 31 et 33 de sortie du circuit 2 sont destinées à fournir des signaux de commande HCT et LCT aux circuits 12 et 14, respectivement référencés aux potentiels des bornes 39 et 13. En d'autres termes, les signaux HCT et LCT varient respectivement entre les potentiels des bornes 35 et 39 et entre les potentiels des bornes 37 et 13.

Dans l'exemple de la figure 2, on suppose que la tension VccH, d'amplitude Vcc référencée à la borne 39, est fournie, à partir de la tension Vcc, par un montage 4 (BOOTSTRAP) de type Bootstrap distinct du circuit 2. La tension VccH est alors appliquée sur une borne 25 reliée, de préférence connectée, à la borne 35. Toutefois, le circuit 4 peut être intégré au circuit 2. Un exemple de montage de type Bootstrap sera illustré ultérieurement en relation avec la figure 4.

De préférence, le circuit 14 est directement alimenté par la tension Vcc référencée à la masse et est directement commandé par le signal CTL. Ainsi, la borne 37 est reliée, de préférence connectée, à la borne 21, et la borne 33 est reliée, de préférence connectée, à la borne 23.

Selon les modes de réalisation décrits, on prévoit de fournir le signal haut HCT par l'intermédiaire d'un transistor M6, de préférence un transistor à canal N, reliant les bornes 31 et 39. La borne 31 est par ailleurs reliée, par un élément résistif R2, à la borne 35. Quand le transistor M6 est bloqué, la borne 31 est tirée au potentiel de la borne 39 par l'élément résistif R2 (fonction pull-up). Quand le transistor M6 est passant, la borne 31 est forcée au potentiel de la borne 39. La grille G6 du transistor M6 est reliée à la borne 35 par un élément résistif R1. Au repos, la grille du transistor M6 est par conséquent tirée au potentiel de la borne 35. Au repos, le transistor M6 est donc passant et le signal HCT est donc à l'état bas (potentiel COM de la borne 39).

La commande du transistor M6, à partir du signal CTH (qui est référencé à la masse), s'effectue à l'aide de deux branches parallèles 7 et 8, entre la grille G6 du transistor M6 et la masse (borne 13), permettant respectivement de tirer un courant sur la borne 35 quand la borne 39 est à un potentiel élevé ou d'injecter un courant quand la borne 39 est à un potentiel faible. En pratique, le potentiel COM élevé est le potentiel HV (transistor HM passant) et le potentiel COM bas est la masse GND (transistor LM passant). Toutefois, ces notions "élevé" et "faible" sont conditionnées par les composants qui sont décrits ci-après. Le rôle des branches 7 et 8 est, lorsque le signal CTH est actif (état haut Vcc), de bloquer le transistor M6 et de porter ainsi le signal HCT à l'état haut (potentiel COM + Vcc de la borne 35).

La branche 7 comporte, en série entre la grille ou noeud G6 et la borne 13, un transistor M3, une résistance R4 et un transistor M1. Les transistors M1 et M3 sont, de préférence, des transistors MOS à canal N. La grille du transistor M1 est reliée, de préférence connectée, à la borne 21 et reçoit donc le signal CTH. La grille du transistor M3 est reliée, de préférence connectée, à la borne 39. Par ailleurs, la grille du transistor M3 est reliée à sa source (donc à la résistance R4) par une diode à avalanche D1 (typiquement une diode Zener) ou un élément écrêteur. L'anode de la diode D1 est côté source du transistor M3. La source du transistor M1 est reliée, de préférence connectée, à la borne 13.

La branche 8 comporte, en série entre la grille ou noeud G6 et la borne 13, un transistor M4, un élément écrêteur (par exemple une diode Zener D3), une diode D2, et un transistor M2. Les transistors M2 et M4 sont, de préférence, des transistors à canal N. Le point milieu entre le transistor M4 et la diode D3 est relié, de préférence connecté, à la borne 39 (la source du transistor M4 et l'anode de la diode D3 sont donc connectées à la borne 39). L'anode de la diode D2 est côté transistor M2 dont la source est reliée, de préférence connectée, à la borne 13. La grille du transistor M2 est reliée, par un montage inverseur, à la borne 21 de façon à recevoir l'inverse du signal CTH. Par exemple, la grille du transistor M2 est reliée à la borne 37 par un élément résistif R7 et est reliée à la borne 13 par un transistor M5, de préférence un transistor à canal N. La grille du transistor M5 est reliée, de préférence connectée, à la borne 21. La source du transistor M5 est reliée, de préférence connectée, à la borne 13. Enfin, une résistance R3 tire le drain du transistor M2 à l'état bloqué au potentiel Vcc et sert à polariser la diode D2.

Le transistor M1 est passant quand le signal CTH est à l'état haut et le transistor M2 est passant quand le signal CTH est à l'état bas (quand le transistor M5 est bloqué).

Le transistor M3 de la branche 7 fonctionne en grille commune. Par conséquent, quand le transistor M1 est rendu passant et que le niveau du potentiel COM est élevé (de l'ordre de HV), la source du transistor M3 prend un potentiel inférieur à celui de sa grille, ce qui le rend passant. La chute de tension grille-source est limitée par la diode D1 (par exemple à de l'ordre de 4 à 10 volts) de façon à protéger le transistor M3. Un courant circule alors dans la branche 7 en étant tiré sur la borne 35, ce qui bloque le transistor M6. La résistance R4 sert de limiteur de courant. Elle a, par exemple, une valeur de quelques dizaines de kilo-ohms. La résistance R4 peut être remplacée par un circuit à transistors limiteur de courant. Si le potentiel de la borne 39 est trop faible (de l'ordre de 0 V), la grille du transistor M3 reste à un potentiel trop bas pour que le transistor M3 puisse être rendu passant quand sa source est approximativement à 0 (transistor M1 passant). Quand le transistor M1 est bloqué (signal CTH au repos), la source du transistor M3 est en l'air et celui-ci est donc bloqué.

Le transistor M4 de la branche 8 fonctionne en source commune. Au repos (signal CTH à l'état bas), le transistor M5 est bloqué et le transistor M2 est passant. Par conséquent, la diode D2 est bloquée et le transistor M4 est donc également bloqué quelle que soit l'évolution du potentiel COM entre 0 V et HV. Quand le signal CTH est à l'état haut, le transistor M5 est rendu passant, ce qui bloque le transistor M2. La diode D2 est alors polarisée en direct par la résistance R3. Si le potentiel COM est suffisamment bas, la tension grille-source du transistor M4 devient suffisante pour le rendre passant et un courant est alors tiré de la borne 35 pour bloquer le transistor M6. La diode D3 sert de diode de protection lors de transitoires sur la borne 39 (lors des commutations des transistors HM et LM).

On notera que la résistance R4, le transistor M1 et la diode D2 doivent être dimensionnés pour supporter la haute tension HV imposée entre les bornes 39 et 13 quand l'interrupteur de puissance HM (figure 1) est passant. La résistance R4 et la diode D2 servent à transmettre l'information contenue dans le signal CTH.

Tous les autres composants du montage de la figure 2 (hors circuit Bootstrap 4) sont des composants basse tension.

Selon une variante de réalisation, les deux branches sont réalisées sous la forme de la branche 7, c'est-à-dire que l'on remplace les diodes D2 et D3 et le transistor M4 de la branche 8 par un transistor (monté comme le transistor M3), un écrêteur (monté comme l'écrêteur D1) et un élément résistif (monté comme l'élément résistif R4) entre la grille G6 et le drain du transistor M2. Le fonctionnement est similaire à celui décrit en relation avec la figure 2 pour la branche 7 mais avec les états inverses du signal CTH. Cette variante requiert que le transistor M2 soit haute tension et il faut veiller à ce que les commutations soient suffisamment rapides pour que les deux transistors (M3) connectés à la grille G6 ne conduisent pas simultanément.

La figure 3 illustre, par des chronogrammes, le fonctionnement du circuit de la figure 2. La figure 3(a) représente un exemple d'allure du signal CTH et l'allure correspondante du signal HCT. La figure 3(b) illustre un exemple d'allure du potentiel COM. La figure 3(c) illustre les allures correspondantes des courants ID2 dans la diode D2 et IR4 dans la résistance R4.

On voit que, quand la tension de la borne 35 référencée à la masse (potentiel COM) est élevée, la branche active est la branche 7 de la résistance R4. Cependant, quand le potentiel COM est nul, la branche active est la branche 8 de la diode D2.

La figure 4 représente, de façon très schématique, un exemple de montage Bootstrap qui peut être utilisé pour fournir la tension VccH.

Pour simplifier, seuls les éléments intervenant dans le fonctionnement du montage Bootstrap 4 ont été représentés en figure 4.

Le montage 4 comporte, entre la borne 27 d'application de la tension Vcc (référencée à la masse 13) et la borne 35, une résistance R10 en série avec une diode D10, la cathode de la diode D10 étant côté borne 35. La borne 35 est par ailleurs reliée, par un condensateur C10, à la borne 39. Lorsque l'interrupteur LM est fermé, la tension Vcc charge positivement par rapport à la borne 39 le condensateur C10 et crée ainsi une alimentation auxiliaire de tension VccH, référencée à la borne 39, pour le circuit 12. La diode D10, conditionnant le sens de circulation de la borne 27 vers le condensateur C10, évite que ce condensateur C10 se décharge autrement que pour alimenter le circuit 12. La résistance R10 sert à limiter les courants d'appel lors de la recharge du condensateur C10. La diode D10 est une diode haute tension car elle doit tenir la tension VH + VccH lorsque le transistor LM est bloqué.

Le montage de la figure 4 ne constitue qu'un exemple et tout autre montage adapté à fournir une tension d'amplitude Vcc entre les bornes 25 et 39 pourra être utilisé.

Un avantage des modes de réalisation décrits est qu'ils évitent le recours à un moyen d'isolation galvanique.

Un autre avantage des modes de réalisation décrits est qu'ils n'utilisent que des composants intégrables.

Ces modes de réalisation trouvent un intérêt particulier pour une réalisation intégrée dans une technologie permettant de disposer de transistors haute tension et basse tension sur une même puce. Dans un tel contexte, la suppression d'un élément d'isolation galvanique de type transformateur ou optocoupleur est particulièrement intéressante.

Les différents éléments résistifs R1, R2, R3, R4, R7 et R10 peuvent être constitués de résistances ou de transistors normalement passants (normally-On), par exemple des transistors à canal N à déplétion. Les résistances R1, R2, R3, R7 et R10 ont par exemple des valeurs de l'ordre du kiloohms.

La résistance R4 haute tension peut, par exemple, être formée d'un transistor à haute mobilité en technologie GaN (Nitrure de Gallium), généralement désigné HEMTS. De même, la diode D1 peut avantageusement être réalisée à base de transistors HEMT (High Electron Mobility Transistor) normally-On montés en écrêteur.

Les transistors M1, M2, M3, M4, M5 et M6 sont de préférence tous des transistors normalement bloqués (normally OFF), par exemple des transistors à canal N à enrichissement.

La diode D2 est par exemple une diode Schottky ou un transistor bloqué monté en inverse.

Un bras d'onduleur ou de commutation tel qu'illustré par la figure 2 peut être utilisé dans tout onduleur, qu'il s'agisse d'un onduleur de courant ou d'un onduleur de tension et plus généralement dans toute structure où un interrupteur de puissance doit être commandé en ayant une de ses bornes à un potentiel flottant par rapport aux potentiels d'un signal (numérique) de commande.

Par exemple, dans le cas d'un onduleur de courant triphasé, trois bras du type de celui représenté en figure 1 sont associés en parallèle et les points milieux respectifs des bras définissent les trois phases de courant alternatif. Les interrupteurs de puissance sont commandés pour qu'à chaque cycle un interrupteur haut d'un bras soit passant avec un interrupteur bas d'un autre bras pour découper un courant continu en trois courants alternatifs sur les points milieux respectifs des différents bras. En pratique, dans un onduleur de courant, une diode est généralement prévue en série avec chaque interrupteur HM, LM afin de le rendre unidirectionnel en courant.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, bien que l'on ait fait référence à un bras d'onduleur de courant, les modes de réalisation décrits se transposent sans difficulté à un circuit de commande d'un transistor haute tension dont on souhaite décaler le niveau d'un signal de commande basse tension. De plus, on pourrait également prévoir, dans des applications où le potentiel flottant COM de référence de l'étage haut reste supérieur au potentiel GND de référence du signal de consigne basse tension, de ne prévoir que la branche 7. En outre, bien que les modes de réalisation décrits se prêtent particulièrement bien à une réalisation à base de transistors à canal N, ils se transposent à des réalisations à base de transistors à canal P.

Enfin, la mise en oeuvre pratique des modes de réalisation et variantes décrits est à la portée de l'homme du métier à partir des indications fonctionnelles données ci-dessus, en particulier pour ce qui est des valeurs à donner aux éléments résistifs, aux diodes.

## Revendications

1. Circuit de conversion d'un premier signal de commande (CTH), référencé à un premier potentiel (GND), en un deuxième signal (HCT) référencé à un deuxième potentiel variable (COM), comportant :
un premier transistor (M6) entre une première borne (31) de fourniture dudit deuxième signal (HCT) et une deuxième borne (39) audit deuxième potentiel variable ; et
au moins une première branche (7) comportant, en série entre une grille (G6) du premier transistor (M6) et une troisième borne (13) audit premier potentiel (GND), un deuxième transistor (M3), un premier élément résistif (R4) et un troisième transistor (M1), une grille du troisième transistor (M1) étant destinée à recevoir le premier signal (CTH) et une grille du deuxième transistor (M3) étant reliée à la deuxième borne (39), la grille du deuxième transistor (M3) étant en outre reliée, par un premier élément écrêteur (D1), à sa source,
la grille (G6) du premier transistor (M6) étant reliée, par un deuxième élément résistif (R1), à une troisième borne (35) à un troisième potentiel (HV), supérieur au deuxième potentiel (COM).

2. Circuit selon la revendication 1, dans lequel ledit élément écrêteur (D1) force une mise en conduction du deuxième transistor (M3) lorsque le troisième transistor (M1) est rendu passant.

3. Circuit selon la revendication 1 ou 2, dans lequel la première branche (7) est active lorsque le deuxième potentiel variable (COM) est supérieur au premier potentiel (GND).

4. Circuit selon l'une quelconque des revendications 1 à 3, dans lequel le premier transistor (M6) est rendu passant quand le premier signal (CTH) est dans un état rendant non conducteur le troisième transistor.

5. Circuit selon l'une quelconque des revendications 1 à 4, comportant en outre une deuxième branche (8) en parallèle avec la première branche (7), entre la grille (G6) du premier transistor (M6) et la troisième borne (13).

6. Circuit selon la revendication 5, dans lequel la deuxième branche (8) est destinée à être active lorsque le deuxième potentiel variable (COM) est sensiblement égal au premier potentiel (GND).

7. Circuit selon la revendication 5 ou 6, dans lequel la deuxième branche (8) comporte, en série entre la grille (G6) du premier transistor (M6) et la troisième borne (13), un quatrième transistor (M4), un deuxième élément écrêteur (D3), une diode (D2) et un cinquième transistor (M2), une grille du cinquième transistor (M2) étant destinée à recevoir l'inverse du premier signal (CTH) et une source du quatrième transistor (M4) étant reliée à la deuxième borne (39), la grille du quatrième transistor (M4) étant en outre reliée au point milieu entre le deuxième élément écrêteur (D3) et la diode (D2).

8. Circuit selon la revendication 5 ou 6, dans lequel la deuxième branche (8) est de structure similaire à la première branche (7), en étant commandée par l'inverse du premier signal.

9. Circuit selon l'une quelconque des revendications 1 à 8, dans lequel les transistors sont des transistors MOS à canal N.

10. Bras d'onduleur comportant :
un premier interrupteur (HM) et un deuxième interrupteur (LM) en série entre une première borne (11) et une deuxième borne (13) d'application d'une première tension (HV) ;
un circuit (2) selon l'une quelconque des revendications 1 à 9, la deuxième borne (39) au potentiel variable (COM) représentant le point milieu de l'association en série des deux interrupteurs.

11. Bras d'onduleur selon la revendication 10, dans lequel le deuxième signal (HCT) est destiné à commander le premier interrupteur (HM).

12. Bras d'onduleur selon la revendication 10 ou 11, dans lequel l'amplitude de la première tension (HV) est supérieure, dans un rapport d'au moins dix, à l'amplitude du premier signal de commande (CTH).
